# EUROPÄISCHE PATENTSCHRIFT

(11) **EP 0 867 692 B1**
(45) Veröffentlichungstag und Bekanntmachung des Hinweises auf die Patenterteilung: **02.05.2007**
(21) Anmeldenummer: 98104627.9
(22) Anmeldetag: 13.03.1998
(51) Int. Cl.: G01D 5/16, G01R 33/09, G01B 7/30

(54) **Einrichtung zur berührungslosen Positionserfassung eines Objektes und Verwendung der Einrichtung**
Device for contact-free determination of an object's position and use of the device
Dispositif de détection sans contact de la position d'un objet et utilisation dudit dispositif

(30) Priorität: 26.03.1997 DE 19712833
(43) Veröffentlichungstag der Anmeldung: 30.09.1998
(73) Patentinhaber: SIEMENS AKTIENGESELLSCHAFT, 80333 München (DE)
(72) Erfinder: Clemens, Wolfgang, Dr., 90617 Puschendorf (DE); Vieth, Michael, Dipl.-Phys., 91096 Möhrendorf (DE); Schmidt, Ludwig, Dipl.Ing., 80637 München (DE)

(56) Entgegenhaltungen:
- EP-A- 0 707 195
- WO-A-94/17426
- WO-A-97/13120

## Beschreibung

Die Erfindung bezieht sich auf eine Einrichtung zur berührungslosen Erfassung der Position eines Objektes bezüglich einer vorgegebenen Ausgangslage. Die Einrichtung umfaßt dabei eine magnetfelderzeugende Vorrichtung und eine Sensorvorrichtung. Die magnetfelderzeugende Vorrichtung bildet an einer gedachten Bezugslinie einen Magnetpol oder längs der Linie mehrere hintereinandergereihte, wechselnde Magnetfeldrichtungen erzeugende Magnetpole. Die Sensorvorrichtung enthält wenigstens einen stromdurchflossenen Sensor mit erhöhtem magnetoresistiven Effekt, der ein Schichtensystem mit mindestens einer magnetisch weichen Meßschicht mit einer in ihrer Schichtebene drehbaren Magnetisierung und mindestens einen magnetisch härteren Biasteil mit einer zumindest weitgehend unveränderten Magnetisierung aufweist. Mit dieser Sensorvorrichtung oder mit der magnetfelderzeugenden Vorrichtung ist das Objekt starr verbunden. Die magnetfelderzeugende Vorrichtung ist bezüglich der Sensorvorrichtung so relativ zu bewegen, daß dabei das Magnetfeld des mindestens einen Magnetpols von der Meßschicht des wenigstens einen Sensors erfaßt wird und daß dabei ein der Zahl der erfaßten Magnetpole entsprechendes vielfaches Durchlaufen der Sensorkennlinie oder eines Teils derselben bewirkt wird, wobei im wesentlichen nur eine Richtungsabhängigkeit des magnetoresistiven Effektes des wenigstens einen Sensors ausgenutzt wird. Die Erfindung betrifft ferner die Verwendung einer solchen Einrichtung. Eine entsprechende Einrichtung und deren Verwendung sind der WO 94/17426 zu entnehmen.

In Schichten aus ferromagnetischen Übergangsmetallen wie Ni, Fe oder Co und deren Legierungen kann eine Abhängigkeit des elektrischen Widerstandes von der Größe und der Richtung eines das Material durchdringenden Magnetfeldes gegeben sein.

Den bei solchen Schichten auftretenden Effekt nennt man "anisotropen Magnetowiderstand (AMR)" oder "anisotropen magnetoresistiven Effekt". Er beruht physikalisch auf den unterschiedlichen Streuquerschnitten von Elektronen mit unterschiedlichem Spin und der Spinpolarität des D-Bandes. Die Elektronen werden als Majoritäts- bzw. Minoritätselektronen bezeichnet. Für entsprechende magnetoresistive Sensoren wird im allgemeinen eine dünne Schicht aus einem solchen magnetoresistiven Material mit einer Magnetisierung in der Schichtebene vorgesehen. Die Widerstandsänderung bei Drehung der Magnetisierung bezüglich der Richtung eines über den Sensor geleiteten Stromes kann dann einige Prozent des normalen isotropen (= ohm'schen) Widerstandes betragen.

Ferner sind seit einiger Zeit magnetoresistive Mehrschichtensysteme bekannt, welche mehrere, zu einem Stapel angeordnete ferromagnetische Schichten enthalten, die jeweils durch metallische Zwischenschichten voneinander getrennt sind und deren Magnetisierungen jeweils in der Schichtebene liegen. Die Dicken der einzelnen Schichten sind dabei deutlich geringer als die mittlere freie Weglänge der Leitungselektronen gewählt. In solchen Mehrschichtensystemen kann nun zusätzlich zu dem erwähnten anisotropen magnetoresistiven Effekt AMR ein sogenannter "giant-magnetoresistiver Effekt" oder "Giant-Magnetowiderstand (GMR)" auftreten (vgl. z.B. EP 0 483 373 A). Ein solcher GMR-Effekt beruht auf der unterschiedlich starken Streuung von Majoritäts- und Minoritäts-Leitungselektronen an den Grenzflächen zwischen den ferromagnetischen Schichten und den dazu benachbarten Schichten sowie auf Streueffekten innerhalb dieser Schichten, insbesondere bei Verwendung von Legierungen. Der GMR-Effekt ist dabei ein isotroper Effekt. Er kann erheblich größer sein als der anisotrope Effekt AMR. In entsprechenden, einen GMR-Effekt zeigenden Mehrschichtensystemen sind benachbarte metallische Schichten zunächst entgegengesetzt magnetisiert, wobei eine Biasschicht bzw. ein Biasschichtteil magnetisch härter als eine Meßschicht ist. Unter Einfluß eines äußeren Magnetfeldes, d.h. einer in der Schichtebene ausgeprägten Komponente dieses Feldes, kann sich dann die anfängliche antiparallele Ausrichtung der Magnetisierungen in eine parallele umwandeln. Bei entsprechenden Magnetfeldsensoren wird diese Tatsache ausgenutzt.

Ein entsprechender Sensor geht aus der eingangs genannten WO-Schrift hervor. Er ist Teil einer Einrichtung zur berührungslosen Erfassung einer Winkelposition eines Objektes. Hierzu ist das Objekt starr mit einem stabförmigen, zwei Magnetpole bildenden Permanentmagneten verbunden, der in einer zu einer Meßschichtebene parallelen Ebene drehbar über der Meßschicht so angeordnet ist, daß seine Drehachse mit der zentralen Normalen auf die Meßschichtoberfläche zusammenfällt. Der Magnet erzeugt mit seinen beiden Magnetpolen in der Meßschicht Magnetfeldkomponenten, die somit gegenüber einer magnetischen Vorzugsachse eines Biasteils des Sensors drehbar sind und deshalb zu einer entsprechenden Drehung der Magnetisierung in der magnetisch weicheren Meßschicht führen. Bei der Drehung des Magneten wird dabei ein der Zahl der erfaßten Magnetpole entsprechend vielfaches Durchlaufen der Sensorkennlinie oder eines Teils derselben bewirkt, wobei im wesentlichen nur eine Richtungsabhängigkeit des magnetoresistiven Effektes des wenigstens einen Sensors ausgenutzt wird. Der elektrische Widerstand des Sensors hängt also vom Winkel zwischen der Magnetisierung der Meßschicht und der magnetischen Vorzugsrichtung des Biasteils ab. Diese Abhängigkeit ist im allgemeinen anisotrop aufgrund der vorgegebenen Form (Geometrie) des Schichtaufbaus des Sensors. Eine entsprechende Einrichtung zum Erfassen einer Winkelposition, die insbesondere ein kontaktloses Potentiometer bilden kann, ist jedoch eingeschränkt auf eine gemeinsame Symmetrieachse des Magneten und des Sensors, um welche entweder der Magnet oder der Sensor selbst drehbar angeordnet ist.

Aufgabe der vorliegenden Erfindung ist es, die bekannte Einrichtung mit den eingangs genannten Merkmalen dahingehend auszugestalten, daß eine derartige Einschränkung nicht mehr gegeben ist.

Diese Aufgabe wird erfindungsgemäß mit den Merkmalen des Anspruchs 1 gelöst. Dabei soll die magnetfelderzeugende Vorrichtung bezüglich der Sensorvorrichtung so angeordnet sein, daß der wenigstens eine Sensor gegenüber der gedachten Bezugslinie des mindestens einen Magnetpols seitlich versetzt ist, wobei eine zentrale Normale auf der Polfläche des mindestens einen Magnetpols zumindest annähernd in der Ebene der Meßschicht des Schichtensystems des wenigstens einen Sensors oder in einer dazu parallelen Ebene liegen. D.h., bei der erfindungsgemäßen Einrichtung sollen auch geringfügige Abweichungen der beanspruchten Ausrichtung der zentralen Normalen um einige wenige Grad mit eingeschlossen sein.

Die mit dieser Ausgestaltung der Positionserfassungsvorrichtung verbundenen Vorteile sind insbesondere darin zu sehen, daß zum einen eine kontaktlose Erfassung von Winkelpositionen von Objekten im gesamten Winkelbereich von 360° oder von Linearpositionen zu realisieren ist und daß zum anderen die Anforderungen an die erforderliche Genauigkeit der Montagepositionen der magnetfelderzeugenden Vorrichtung und der Sensorvorrichtung vermindert sind. Denn mit der Verwendung von mindestens einem Sensor für die Sensorvorrichtung, der ein Schichtensystem mit erhöhtem magnetoresistiven Effekt aufweist, wird hier bei einem seitlichen Vorbeiführen des mindestens einen Magnetpols an der Sensorvorrichtung auf der Bezugslinie im wesentlichen nur die Abhängigkeit des Sensormeßsignals von der Richtung des äußeren Magnetfeldes, nicht aber von dessen Feldstärke ausgenutzt.

Mit der erfindungsgemäßen Einrichtung ist sowohl eine lineare Position als auch eine Drehposition eines beliebigen Objektes berührungslos zu erfassen. Die Einrichtung weist zwei Haupteinheiten auf, nämlich eine Vorrichtung zur Erzeugung einer magnetischen Feldkomponente sowie eine Vorrichtung zur Detektion dieser Magnetfeldkomponente, um ein im wesentlichen nur von der Magnetfeldrichtung abhängiges Ausgangssignal zu erzeugen. Eine dieser beiden Vorrichtungen ist starr mit dem Objekt verbunden, so daß dessen Position bezüglich einer vorgegebenen Ausgangslage bzw. relativ zu der Position der anderen Vorrichtung zu erfassen ist. Die magnetfelderzeugende Vorrichtung weist einen oder mehrere an der Sensor- oder Detektionsvorrichtung ein- oder mehrmals vorbeizuführende und dieser zugewandte Magnetpole auf, wobei vorzugsweise ein seitlicher Abstand zwischen der Sensorvorrichtung und dem mindestens einen Magnetpol eingehalten ist. Ist nur ein Magnetpol vorgesehen, so kann dieser an einer gedachten Bezugslinie liegend angesehen werden. Bei mehreren Magnetpolen sollen diese längs einer entsprechenden gedachten Bezugslinie gesehen hintereinandergereiht sein, wobei die von den Magnetpolen erzeugten Magnetfelder längs dieser Linie wechselnde, vorzugsweise alternierende oder periodisch wechselnde Magnetfeldrichtungen bezüglich der Sensorvorrichtung haben sollen. Die Bezugslinie kann dabei eine gerade oder eine gekrümmte Linie darstellen. Im Falle einer Geraden ist insbesondere eine Erfassung einer Linearposition eines Objektes möglich. Mit einer gekrümmten Linie kann insbesondere eine Umfangslinie eines Kreises ausgebildet sein, wie er z.B. von einem Polrad gebildet wird. Damit lassen sich vorzugsweise Winkelpositionen zwischen 0° und 360° erfassen. Die als Sensorvorrichtung anzusehende und bzgl. der Magnetfeldrichtung empfindliche Vorrichtung umfaßt mindestens einen stromdurchflossenen Sensor. Dabei können mehrere sich entsprechende Sensoren zu der Sensorvorrichtung elektrisch verschaltet sein und beispielsweise eine Wheatstone'sche Brücke bilden. Jeder Sensor weist ein Mehrschichtensystem auf, das einen erhöhten magnetoresistiven Effekt, insbesondere einen sogenannten GMR-Effekt, zeigt. Das Schichtensystem enthält hierzu mindestens eine magnetisch weichere Meßschicht mit einer in ihrer Schichtebene drehbaren Magnetisierung. Parallel dazu ist ein Biasteil mit einer Biasschicht oder einem Biasschichtensystem angeordnet, wobei der Biasteil magnetisch härter und unter dem Einfluß des Magnetfeldes des mindestens einen Magnetpoles eine zumindest weitgehend unveränderte Magnetisierung besitzt. Entsprechende Mehrschichtensysteme mit GMR-Effekt sind z.B. aus den Schriften EP-A-0 483 373, DE-A-42 32 244, DE-A-42 43 357 oder DE-A-42 43 358 bekannt.

Durch die hohe Empfindlichkeit von giant-magnetoresistiven Sensoren ist bei der erfindungsgemäßen Positionserfassungseinrichtung keine differentielle Anordnung mehr nötig, wie sie z.B. bei Hallsensoren (vgl. z.B. Datenbuch "Magnetic Sensors" der Siemens AG, 1989, Seite 57) erforderlich wird; dadurch lassen sich kleinere Polabstände zwischen benachbarten Magnetpolen ermöglichen, so daß dann eine entsprechend höhere Auflösung und/oder eine entsprechende Miniaturisierung erreichbar ist.

Bei einer Positionserfassungseinrichtung mit diesen Merkmalen soll erfindungsgemäß deren magnetfelderzeugende Vorrichtung bezüglich der Sensorvorrichtung in vorbestimmter Weise angeordnet sein:
Hierzu werden die Ebene der Meßschicht des Mehrschichtensystems des mindestens einen Sensors sowie die Polfläche-des mindestens einen Magnetpols der magnetfelderzeugenden Vorrichtung an der gedachten Bezugslinie betrachtet. Dabei soll sich der mindestens eine Magnetpol nicht oberhalb des Bereichs der Oberfläche der Meßschicht in dem senkrecht auf der Oberfläche stehenden, säulenartigen Volumen wie beim Stand der Technik gemäß der genannten WO-Schrift befinden; vielmehr sollen der mindestens eine Magnetpol und damit die gedachte Bezugslinie außerhalb dieses Bereichs liegen oder nur an diesem Bereich angrenzen. Eine derartige Anordnung des Sensors wird als "seitlich versetzte" Anordnung angesehen. Insbesondere wird zwischen der Meßschicht bzw. dem Sensor und dem Magnetpol ein als seitlicher Abstand anzusehender Abstand eingehalten. Zugleich soll die magnetfelderzeugende Vorrichtung so ausgerichtet sein, daß eine der Mitte der Polfläche zuzuordnende zentrale Normale entweder zumindest annähernd in der Ebene der Meßschicht verläuft oder in einer dazu parallelen Ebene liegt (unter Zulassung geringfügiger Abweichungen dieser Ausrichtung der Normalen). Bei einer derartigen Anordnung wird von der Überlegung ausgegangen, daß bei dem für den mindestens einen Sensor verwendeten Mehrschichtensystem mit erhöhtem magnetoresistiven Effekt innerhalb eines üblichen Meßbereichs bzw. Meßfensters eine Abhängigkeit von der Feldstärke praktisch keine Rolle spielt, sondern nur die Abhängigkeit von der Ausrichtung des Magnetfeldes bezüglich der Ausgangslage der Magnetisierung in der Meßschicht ausgenutzt wird.
Außerdem sollen die magnetfelderzeugende Vorrichtung und die Sensorvorrichtung relativ zueinander so zu bewegen sein, daß dabei das Magnetfeld des mindestens einen Magnetpols der magnetfelderzeugenden Vorrichtung von der Meßschicht des Mehrschichtensystems des wenigstens einen Sensors erfaßt wird und bei der Führung des mindestens einen Magnetpols durch den Erfassungsbereich der Sensorvorrichtung ein der Anzahl der vorhandenen bzw. erfaßten Magnetpole entsprechend vielfaches Durchlaufen der Sensorkennlinie oder eines Teils derselben bewirkt wird. Als Sensorkennlinie werden dabei die in einem Diagramm darstellbaren widerstandswerte angesehen, die die Sensorvorrichtung bei einem Vorbeiführen des mindestens einen Magnetpols an ihrer mindestens einen Meßschicht annehmen kann.
Selbstverständlich ist es auch möglich, daß die Magnetpole der magnetfelderzeugenden Vorrichtung wiederholt durch den Erfassungsbereich der Sensorvorrichtung geführt werden (oder umgekehrt). Dann wird die Sensorkennlinie oder deren Teillinie entsprechend der Anzahl an von der Sensorvorrichtung insgesamt nacheinander erfaßten Magnetpolen oft durchlaufen.

Besonders vorteilhaft ermöglicht eine erfindungsgemäße Positionserfassungseinrichtung den Aufbau eines kontaktlosen Potentiometers.

Vorteilhafte Ausgestaltungen der erfindungsgemäßen Positionserfassungseinrichtung gehen aus den abhängigen Ansprüchen hervor.

Zur weiteren Erläuterung der Erfindung wird nachfolgend auf die Zeichnung Bezug genommen. Es zeigen jeweils schematisch
- die Figuren 1 und 2: in Auf- bzw. Seitenansicht eine erste Ausführungsform einer Drehpositionserfassungseinrichtung mit einem Polrad,
- die Figur 3: in Schnittansicht einen Sensor dieser Drehpositionserfassungseinrichtung,
- die Figuren 4 und 5: in Seitenansicht eine zweite bzw. eine dritte Ausführungsform einer entsprechenden Einrichtung,
- die Figur 6: in Seitenansicht eine Ausführungsform einer Linearpositionserfassungseinrichtung mit einer linearen Polanordnung,
- die Figur 7: in Aufsicht eine vierte Ausführungsform einer Drehpositionserfassungseinrichtung mit einem Polrad,
und
die Figur 8 in Aufsicht eine fünfte Ausführungsform einer erfindungsgemäßen Drehpositionserfassungseinrichtung mit einem anderen Polrad.
In den Figuren sind sich entsprechende Teile mit denselben Bezugszeichen versehen. Nicht näher dargestellte Teile sind allgemein bekannt, so daß auf deren Beschreibung nachfolgend verzichtet ist.

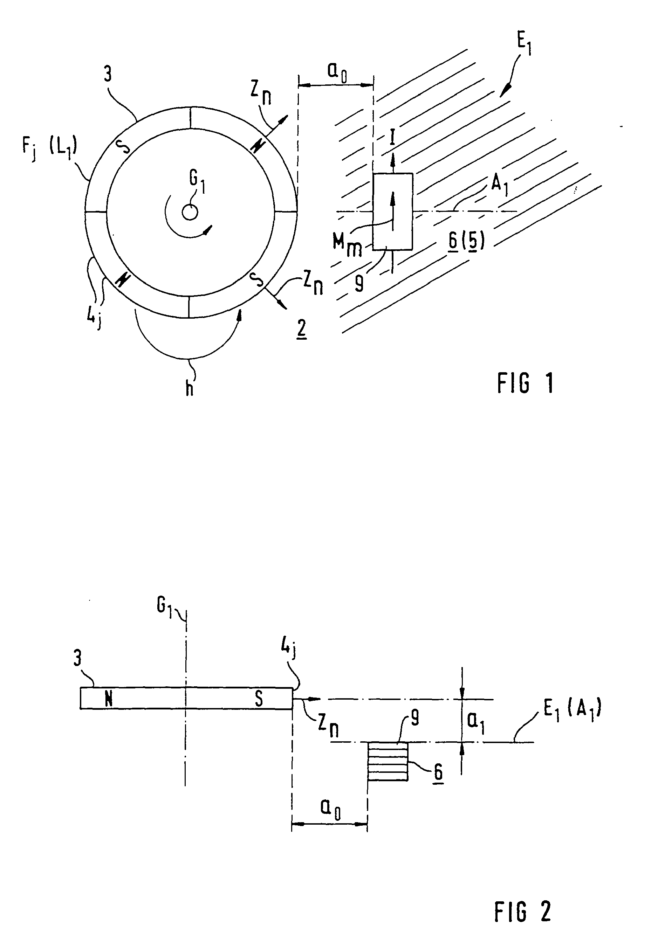

Gemäß der in den Figuren 1 und 2 angedeuteten Ausführungsform einer entsprechenden Einrichtung 2 zur Erfassung einer Drehposition ist deren magnetfelderzeugende Vorrichtung als ein magnetisches Polrad 3 gestaltet. Das Polrad ist um eine Bezugsachse G₁ drehbar gelagert und beispielsweise auf der Achse eines Elektromotors montiert. Es enthält auf einer längs seines Außenumfangs verlaufenden Bezugslinie L₁ in Umfangsrichtung gesehen hintereinanderliegende Magnetpole 4ⱼ mit wechselnder Polarität. Von den n (mit 1 ≤ j ≤ n) Magnetpolen sind in der Figur nur vier gezeigt, zwei mit Polarität N (= Nordpol) und zwei mit Polarität S (= Südpol). Das zwischen benachbarten Polen mit unterschiedlicher Polarität verlaufende Magnetfeld ist durch eine Feldlinie h angedeutet.

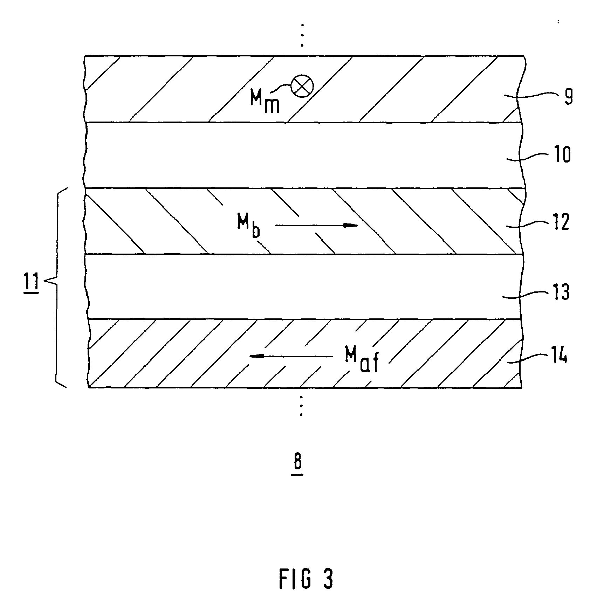

Das Polrad 3 ist in einem Abstand a₀ seiner Bezugslinie L₁ seitlich von einem Sensor 6 einer Sensorvorrichtung 5 entfernt angeordnet. Der in den Figuren gegenüber dem Polrad nicht maßstäblich dargestellte Sensor wird von einem Strom I durchflossen und weist ein an sich bekanntes GMR-Mehrschichtensystem auf. Ein mögliches Ausführungsbeispiel eines geeigneten Mehrschichtensystems geht aus Figur 3 näher hervor. Bei diesem in Figur 3 dargestellten Mehrschichtensystem wird von einer Ausführungsform ausgegangen, wie sie z.B. der WO 94/15223 zu entnehmen ist. Das mit 8 bezeichnete Mehrschichtensystem umfaßt eine weichmagnetische Meßschicht 9 mit einer in der Schichtebene drehbaren Magnetisierung Mₘ. Diese Meßschicht ist über eine Entkopplungsschicht 10 von einem in seinen Magnetisierungen festen Schichtteil 11 magnetisch_entkoppelt. Dieser auch als Biasteil bezeichnete Schichtteil 11 ist vergleichsweise magnetisch härter. Gemäß der dargestellten Ausführungsform enthält er eine Biasschicht 12 mit einer Magnetisierung M_{b}. Diese Schicht 12 ist antiferromagnetisch über eine Kopplungsschicht 13 an eine weitere Magnetschicht 14 mit einer zur Magnetisierung M_{b} entgegengesetzt gerichteten Magnetisierung M_{af} angekoppelt. Man spricht deshalb auch von einem künstlichen Antiferromagneten. Eine derartige Ausbildung des Mehrschichtensystems hat insbesondere den Vorteil, daß die Ausrichtung der Magnetisierung Mₘ der Meßschicht 9 praktisch unbeeinflußt von den Magnetisierungen M_{b} und M_{af} des Biasteils 11 ist.

Da die konkrete Ausführungsform des Biasteils bei den für erfindungsgemäße Positionserfassungseinrichtungen verwendbaren Sensoren mit erhöhtem magnetoresistiven Effekt unkritisch ist, kann es sich bei dem Biasteil beispielsweise um einen natürlichen Antiferromagneten handeln, wie er z.B. in den sogenannten "Spin Valve"-Systemen eingesetzt wird. Selbstverständlich ist auch ein durch eine einzige Magnetschicht gebildeter Biasteil geeignet.

Wie ferner aus Figur 1 und insbesondere aus Figur 2 hervorgeht, soll der Sensor 6 bezüglich des Polrades 3 so angeordnet sein, daß eine Bezugsachse G₁ (= Drehachse) des Polrades zumindest annähernd parallel zu einer Normalen auf der durch eine Schraffur angedeuteten Sensorebene E₁ verläuft. Dann liegt eine zentrale Normale Zₙ auf der Polfläche Fⱼ des mindestens einen Magnetpols 4ⱼ in der Ebene E₁ des Sensors bzw. der Ebene der Oberfläche der Meßschicht 9 oder in einer dazu parallelen Ebene. Eine in der Ebene E₁ liegende Bezugsachse A₁ des Sensors 6 braucht nicht unbedingt die Drehachse G₁ zu schneiden. D.h., es ist eine Anordnung des Sensors 6 mit einer entsprechenden Achse möglich, die gegenüber der dargestellten Achse A₁ parallel verschoben ist. Die Bezugsachse A₁ ist insbesondere eine Senkrechte auf die Magnetisierung Mₘ der Meßschicht 9 ohne äußeres Magnetfeld und geht durch das Zentrum der Meßschichtoberfläche.

Bei einer Drehung des Polrades 3 um die Bezugsachse G₁ sind die Magnetpole 4ⱼ mit ihren Polflächen Fⱼ nacheinander dem Sensor 6 direkt zugewandt. Bei einer solchen Drehung wird die Widerstandskennlinie des giant-magnetoresistiven Sensors 6 n-fach durchlaufen. Da die Richtung der Magnetisierung Mₘ der weichmagnetischen Meßschicht 9 im giant-magnetoresistiven Sensor 6 in einem weiten Feldbereich dem einwirkenden Magnetfeld folgt und die Widerstandsänderung des Mehrschichtenpakets nur vom relativen Winkel der Magnetisierungen Mₘ in der Meßschicht bezüglich der Magnetisierung M_{b} in dem Biasteil abhängt, ist das von dem Sensor abgegebene Signal, das die Winkellage des magnetischen Polrades 3 abbildet, vorteilhaft in einem weiten Bereich unabhängig von dem Abstand a₀ zwischen dem Polrad und dem Sensor.

Wie ferner aus Figur 2 entnehmbar ist, braucht die Normale Zₙ nicht unbedingt in der Ebene E₁ des Sensors 6 zu liegen, sondern kann gegenüber dieser Ebene auch um einen Abstand a₁ verschoben sein.

Bei der in den Figuren 1 und 2 gezeigten Drehpositionserfassungseinrichtung 2 kann in dem zwischen dem Polrad 3 und dem Sensor 6 durch den Abstand der Größe a₀ gekennzeichneten Raum eine Trenn- oder Gehäusewand eingefügt werden. Diese Wand muß aus einem nicht-ferromagnetischen Material bestehen. Ein solcher Aufbau läßt sich insbesondere dann vorsehen, wenn beispielsweise das Polrad oder der Sensor in ein Gehäuse eingebaut oder in unterschiedlichen Umgebungsmedien, die durch eine Trennwand voneinander zu trennen sind, angeordnet werden sollen.

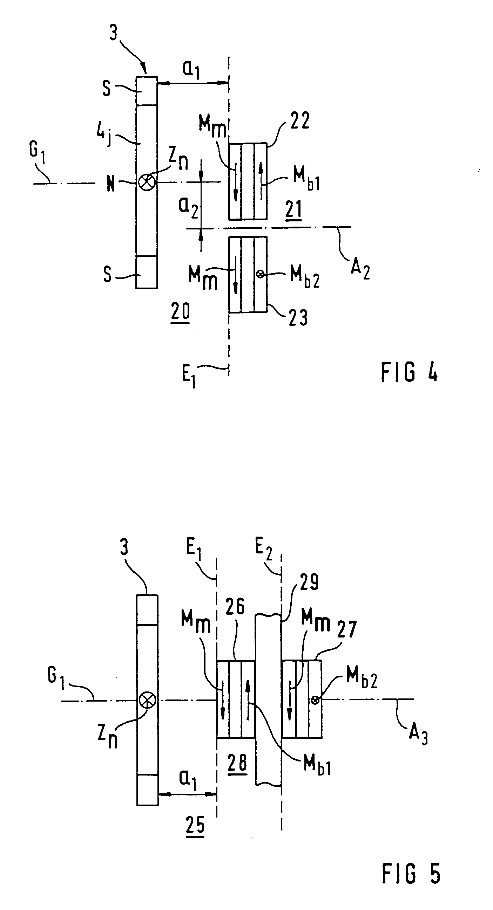

Die in Figur 4 dargestellte Ausführungsform einer Einrichtung 20 zur Erfassung der Drehposition eines Polrades 3 (gemäß Figur 1) mit n Magnetpolen 4ⱼ weist eine Sensorvorrichtung 21 mit einem Paar von magnetoresistiven Sensoren 22 und 23 auf. In der Figur sind die Sensoren gegenüber dem Polrad wiederum nicht maßstäblich - aus Gründen der Übersichtlichkeit vergrößert - dargestellt. Sie sind elektrisch miteinander verschaltet und werden von einem Strom I durchflossen. Ihre Mehrschichtensysteme liegen an einer gemeinsamen Ebene E₁. Parallel zu dieser Ebene ist die zentrale Normale Zₙ jedes Magnetpols 4ⱼ gerichtet. In die Richtung dieser Normalen weist auch die an dieser Stelle der Polfläche Fⱼ austretende Magnetfeldkomponente, die in bekannter Weise durch das Zeichnen ⊗" veranschaulicht ist. Wie ferner aus der Figur hervorgeht, sind die Mehrschichtensysteme der Sensoren 22 und 23 so zueinander ausgerichtet, daß die Richtungen der Magnetisierungen M_{b1} und M_{b2} ihrer Biasteile vorzugsweise rechtwinklig zueinander verlaufen. Eine den Sensoren gemeinsame Bezugsachse A₂, die in Richtung einer Normalen auf der Ebene der Sensoren weist und zentral zwischen den untereinander beabstandeten Sensoren verläuft, schließt mit einer Ebene der Drehachse G₁ des Polrades 3 einen Winkel von 90° ein. Gegenüber dieser Drehachse kann die Bezugsachse A₂ um einen Abstand a₂ seitlich verschoben sein. Die Bezugsachse A₂ braucht dabei nicht in derselben Ebene zu liegen wie die Drehachse G₁. Bei Drehung des Polrades 3 um seine Achse G₁ wird die Widerstandskennlinie der giant-magnetoresistiven Sensoren n-fach (pro Polradumdrehung) durchlaufen, wobei die beiden Sensoren je ein um 90° phasenverschobenes periodisches Signal liefern. Dies führt beispielsweise zu einer besseren Abtastung der durch die Polzahl des magnetischen Polrades vorgegebenen Grundauflösung, als sie mit zwei nur unter Einhaltung eines vorbestimmten Abstandes nebeneinander anordbaren Hallsensoren zu realisieren wäre. Denn die beiden GMR-Sensoren 22 und 23 können vorteilhaft in unmittelbarer Nachbarschaft nebeneinander z.B. auf einem gemeinsamen Chip angeordnet werden. Außerdem ermöglicht die gezeigte Ausführungsform vorteilhaft eine Richtungserkennung der Drehung.

Abweichend von der Positionserfassungsvorrichtung 20 nach Figur 4 sind bei der in Figur 5 gezeigten Ausführungsform einer Drehpositionserfassungseinrichtung 25 die giant-magnetoresistiven Sensoren 26 und 27 ihrer Sensorvorrichtung 28 nicht in einer gemeinsamen Ebene angeordnet, sondern liegen in parallelen Ebenen E1 und E2. Der Aufbau der Mehrschichtensysteme der Sensoren kann entweder auf hybridem Wege oder durch geeignete Beschichtung und Strukturierung eines Wafers 29 entweder auf dessen gegenüberliegenden Flachseiten oder auch auf einer Seite erfolgen. Die Sensoren haben eine gemeinsame Bezugsachse A₃ in Richtung ihrer Flächennormalen. Die z.B. im Bereich der Mitten der Sensoren verlaufende Bezugsachse A₃ liegt wiederum parallel zur Drehachse G₁ des Polrades 3 oder in der Verlängerung der Drehachse G₁. Die Bezugsachse A₃ kann dabei in einer anderen Ebene liegen als die Drehachse G₁. Aufgrund der erlaubten Abstandstoleranzen geben die Sensoren der Einrichtung 25 ein in der Amplitude zumindest annähernd gleiches, aber um 90° phasenverschobenes Signal ab.

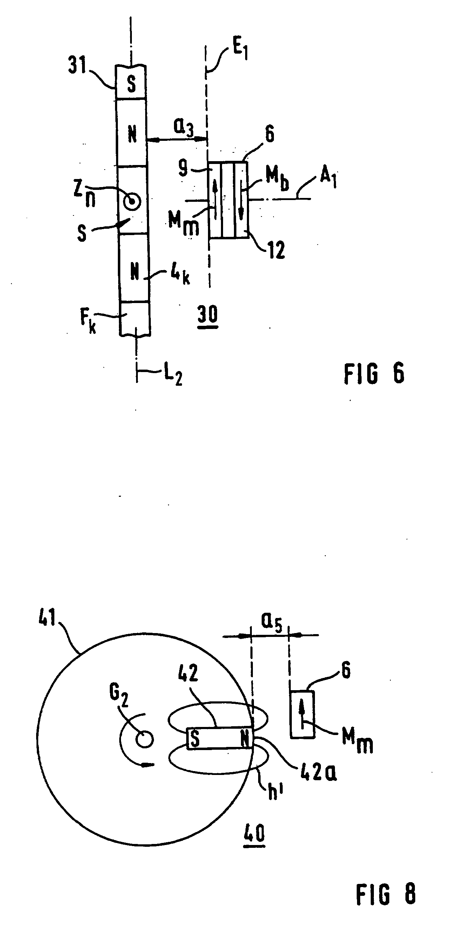

Gemäß den Figuren 1 bis 5 wurde davon ausgegangen, daß eine Bezugslinie L₁ der Magnetpole einer magnetfelderzeugenden Einrichtung eine Umfangslinie eines Polrades 3 beschreibt. Ebensogut kann jedoch die Bezugslinie auch eine Gerade bilden. Eine solche Ausführungsform ergibt sich quasi bei Wahl eines Polrades mit unendlich großem Radius. Ein Ausführungsbeispiel einer Linearpositionserfassungseinrichtung ist in Figur 6 veranschaulicht. Diese mit 30 bezeichnete Einrichtung enthält als magnetfelderzeugende Vorrichtung ein sich längs einer geraden Bezugslinie L₂ erstreckendes magnetisches Band 31 mit n hintereinandergereihten Magnetpolen 4ₖ (mit 1 ≤ k ≤ n) abwechselnder Polarität. Die Bezugslinie L₂ verläuft dabei in senkrechter Richtung bezüglich der Normalen oder Bezugsachse A₁ auf dem giant-magnetoresistiven Sensor 6 (z.B. nach Figur 1). Das magnetische Band soll bezüglich der Achse A₁ so ausgerichtet sein, daß die Achse A₁ in der Ebene der Polflächen Fₖ des Bandes oder in einer dazu parallelen Ebene verläuft. Dann liegt die zentrale Normale Zₙ jeder Polfläche Fₖ wiederum in einer zur Ebene E₁ des Mehrschichtensystems des Sensors 6 parallelen Ebene. Zwischen dem Mehrschichtensystem des Sensors und dem magnetischen Band 31 kann ein seitlicher Abstand a₃ eingehalten werden. D.h., der Sensor 6 kann sich bei dieser Ausführungsform einer Positionserfassungseinrichtung auch seitlich oberhalb der Polflächen Fₖ befinden. Bei Bewegung des Sensors 6 entlang einer zur Bezugslinie L₂ um den Abstand a₃ beabstandeten parallelen Linie oder des magnetischen Bandes entlang der Bezugslinie L₂ wird die Widerstandskennlinie des giant-magnetoresistiven Sensors 6 n-fach durchlaufen. Da die Richtung der Magnetisierung Mₘ der weichmagnetischen Meßschicht 9 des Sensors 6 in einem weiten Feldbereich dem einwirkenden Magnetfeld des magnetischen Bandes 31 folgt und die Widerstandsänderung des Mehrschichtensystems des Sensors nur vom Winkel der Magnetisierungen Mₘ in seiner Meßschicht und M_{b} in seinem Biasteil bzw. der Biasschicht 12 abhängt, ist das von der Sensorvorrichtung abgegebene Signal, das die Position des magnetischen Bandes 31 abbildet, vorteilhaft in einem weiten Bereich unabhängig vom Abstand a₃ zwischen dem magnetischen Band 31 und dem Sensor 6.

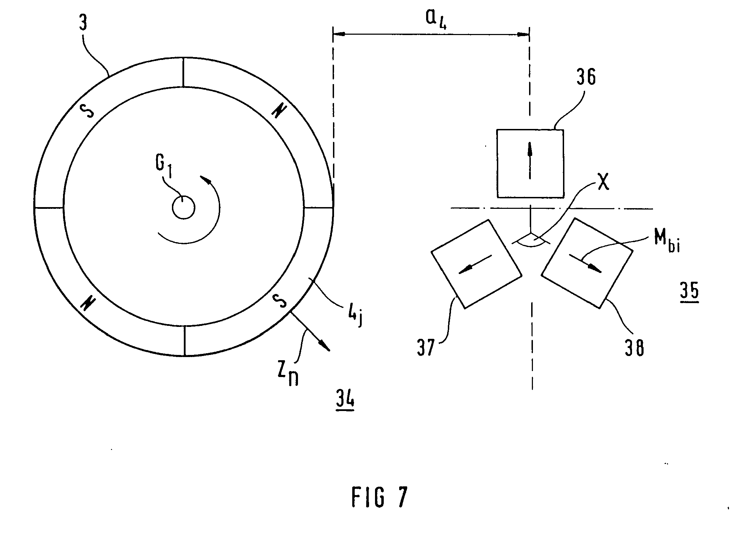

Die in den Figuren 1 bis 6 gezeigten Ausführungsformen von erfindungsgemäßen Positionserfassungseinrichtungen sehen vor, daß die Sensoren so ausgerichtet sind, daß die durch das magnetfelderzeugende Element (Polrad 3 bzw. magnetisches Band 31) noch unbeeinflußten Magnetisierungen Mₘ der weichmagnetischen Meßschicht ihres jeweiligen Mehrschichtensystems parallel zu der Bezugslinie L₁ oder L₂ und gegebenenfalls senkrecht zu der Drehachse G₁ liegen, wobei die Magnetisierungen M_{b} der zugeordneten Biasteile parallel oder senkrecht zu Mₘ gerichtet sind. Eine erfindungsgemäße Positionserfassungseinrichtung ist jedoch nicht auf derartige Ausrichtungen der Magnetisierungen Mₘ und M_{b} beschränkt. So ist es auch möglich, ihre Sensoren so anzuordnen, daß die Magnetisierungen M_{b} ihrer Biasteile schräg bezüglich der jeweiligen Bezugslinie verlaufen. Ein entsprechendes Ausführungsbeispiel ist aus Figur 7 ersichtlich.

Bei der in dieser Figur gezeigten Positionserfassungseinrichtung 34 wird statt der in den Figuren 4 und 5 dargestellten Anordnung einer Sensorvorrichtung mit zwei Sensoren nunmehr eine solche Vorrichtung 35 mit mehr als zwei, beispielsweise mit drei in einer Ebene liegenden Sensoren 36 bis 38 verwendet. Diese von dem Polrad 3 um einen mittleren Abstand a₄ beabstandeten Sensoren sind vorzugsweise unter einem Winkel χ= 120° ihrer in der Sensorebene liegenden Flächenachsen bzw. der Richtungen der Magnetisierungen M_{bi} ihrer Biasteile (mit 1 ≤ i ≤ 3) zueinander angeordnet. Dadurch werden von jedem Sensor nur noch zwei lineare Bereiche von je 60° zu einer 360°-Detektion benötigt anstatt von je 90° gemäß der Ausführungsform nach den Figuren 4 und 5. Auch bei dieser Ausführungsform wird besonders die weitgehende Feldstärkeunabhängigkeit von GMR-Sensoren ausgenutzt, da die drei Sensoren 36 bis 38 unterschiedlich weit entfernt von dem Polrad 3 angeordnet sind.

Figur 8 zeigt eine Ausführungsform einer Drehpositionserfassungseinrichtung 40 mit einem Polrad 41 als magnetfelderzeugender Vorrichtung, die nur einen einzigen magnetischen Doppelpol 42 aufweist. Der z.B. von einem Stabmagneten gebildete Doppelpol ist dabei so angeordnet, daß er sich in radialer Richtung bezüglich der Drehachse G₂ des Polrades 41 erstreckt. D.h., nur ein Magnetpol 42a dieses Stabmagneten ist dem giant-magnetoresistiven Sensor 6 (z.B. gemäß Figur 1) einer Sensorvorrichtung unter Einhaltung eines Abstandes a₅ zugewandt. Das von dem Stabmagneten hervorgerufene Magnetfeld ist durch Feldlinien h' angedeutet. Die gezeigte Einrichtung 40 kann insbesondere zur Erzeugung von Trigger- oder Zählimpulsen verwendet werden.

## Patentansprüche

1. Einrichtung (2, 20, 25, 30, 35, 40) zur berührungslosen Erfassung der Position eines Objektes bezüglich einer vorgegebenen Ausgangslage
- mit einer magnetfelderzeugenden Vorrichtung (3, 31, 41), die an einer gedachten Bezugslinie (L₁, L₂) einen Magnetpol (42a) oder längs der Linie mehrere hintereinandergereihte, wechselnde Magnetfeldrichtungen erzeugende Magnetpole (4ⱼ, 4ₖ)bildet,
- mit einer Sensorvorrichtung (5, 21, 28, 35), die wenigstens einen stromdurchflossenen Sensor (6, 22, 23, 26, 27, 36-38) mit erhöhtem magnetoresistiven Effekt enthält, der ein Schichtensystem (8) mit mindestens einer magnetisch weichen Meßschicht (9) mit einer in ihrer Schichtebene drehbaren Magnetisierung (Mₘ) und mindestens einen magnetisch härteren Biasteil (11) mit einer zumindest weitgehend unveränderten Magnetisierung (M_{b}, M_{b1}, M_{b2}, M_{bi}) aufweist,
sowie
- mit einer starren Verbindung des Objektes mit der Sensorvorrichtung oder der magnetfelderzeugenden Vorrichtung,
wobei die magnetfelderzeugende Vorrichtung bezüglich der Sensorvorrichtung so relativ zu bewegen ist, daß dabei das Magnetfeld (h, h') des mindestens einen Magnetpols von der Meßschicht des wenigstens einen Sensors erfaßt wird und daß dabei ein der Zahl (n) der erfaßten Magnetpole entsprechend vielfaches Durchlaufen der Sensorkennlinie oder eines Teils derselben bewirkt wird, wobei im wesentlichen nur eine Richtungsabhängigkeit des magnetoresistiven Effektes des wenigstens einen Sensors ausgenutzt wird,
**dadurch gekennzeichnet, dass** die magnetfelderzeugende Vorrichtung bezüglich der Sensorvorrichtung so angeordnet ist, daß der wenigstens eine Sensor gegenüber der gedachten Bezugslinie des mindestens einen Magnetpols seitlich versetzt ist, wobei eine zentrale Normale (Zₙ) auf der Polfläche (Fⱼ, Fₖ, 42a) des mindestens einen Magnetpols zumindest annähernd in der Ebene (E₁) der Meßschicht (9) des wenigstens einen Sensors oder in einer dazu parallelen Ebene liegt.

2. Einrichtung nach Anspruch 1, **dadurch gekennzeichnet, daß** der wenigstens eine Sensor (6, 22, 23, 26, 27, 36-38) von der gedachten Bezugslinie (L₁, L₂) des mindestens einen Magnetpols (4ⱼ, 4ₖ, 42a) um einen vorbestimmten Abstand (a₀, a₃, a₅) seitlich versetzt angeordnet ist.

3. Einrichtung nach Anspruch 1 oder 2, **dadurch gekennzeichnet, daß** die Bezugslinie (L₂) zumindest annähernd eine Gerade ist.

4. Einrichtung nach Anspruch 1 oder 2, **dadurch gekennzeichnet, daß** die Bezugslinie (L₁) zumindest annähernd die Umfangslinie eines Polrades (3, 41) ist.

5. Einrichtung nach einem der Ansprüche 1 bis 4, **dadurch gekennzeichnet, daß** die Sensorvorrichtung (21, 28, 35) mehrere elektrisch miteinander verschaltete Sensoren (22, 23; 26, 27; 36-38) umfaßt.

6. Einrichtung nach Anspruch 5, **dadurch gekennzeichnet, daß** zwei Sensoren (21, 22) vorgesehen sind, deren Biasteile ihrer Schichtensysteme Magnetisierungsrichtungen (M_{b1}, M_{b2}) aufweisen, die zumindest weitgehend rechtwinklig zueinander verlaufen.

7. Einrichtung nach Anspruch 5, **dadurch gekennzeichnet, daß** drei Sensoren (36-38) vorgesehen sind, deren Biasteile ihrer Schichtensysteme Magnetisierungsrichtungen (M_{bi}) aufweisen, die untereinander jeweils zumindest annähernd einen Winkel (χ) von 120° einschließen.

8. Einrichtung nach einem der Ansprüche 5 bis 7, **dadurch gekennzeichnet, daß** die Sensoren (22, 23; 36-38) in einer gemeinsamen Ebene (E₁) liegen.

9. Einrichtung nach einem der Ansprüche 5 bis 7, **dadurch gekennzeichnet, daß** die Sensoren (26, 27) in parallelen Ebenen (E₁, E₂) liegen.

10. Verwendung der Einrichtung nach einem der Ansprüche 1 bis 9 zumindest als Teil eines kontaktlosen Potentiometers.

## Claims

1. Device (2, 20, 25, 30, 35, 40) for contactless sensing of the position of an object with respect to a predetermined initial position
- having a magnetic-field-producing apparatus (3, 31, 41), which forms, on an imaginary reference line (L₁, L₂), a magnet pole (42a) or, along the line, a plurality of magnet poles (4ⱼ, 4ₖ), which are arranged one behind the other and produce alternating magnetic field directions,
- having a sensor apparatus (5, 21, 28, 35), which contains at least one current-carrying sensor (6, 22, 23, 26, 27, 36-38) having an increased magnetoresistive effect which has a layer system (8) having at least one magnetically soft measuring layer (9) with a magnetization (Mₘ), which can rotate in terms of the plane of said measuring layer, and at least one magnetically harder bias part (11) with an at least largely unchanged magnetization (M_{b}, M_{b1}, M_{b2}, M_{bi}),
and
- having a rigid connection between the object and the sensor apparatus or the magnetic-field-producing apparatus,
the magnetic-field-producing apparatus needing to be moved with respect to the sensor apparatus relatively in such a way that, in the process, the magnetic field (h, h') of the at least one magnet pole is sensed by the measuring layer of the at least one sensor and that, in the process, the sensor characteristic or a part thereof is run through a number of times, which corresponds to the number (n) of sensed magnet poles, essentially only one directional dependency of the magnetoresistive effect of the at least one sensor being utilized, **characterized in that** the magnetic-field-producing apparatus is arranged with respect to the sensor apparatus such that the at least one sensor is laterally offset with respect to the imaginary reference line of the at least one magnet pole, a central normal (Zₙ) on the pole face (Fⱼ, Fₖ, 42a) of the at least one magnet pole lying at least approximately in the plane (E₁) of the measuring layer (9) of the at least one sensor or in a plane parallel thereto.

2. Device according to Claim 1, **characterized in that** the at least one sensor (6, 22, 23, 26, 27, 36-38) is arranged such that it is laterally offset from the imaginary reference line (L₁, L₂) of the at least one magnet pole (4ⱼ, 4ₖ, 42a) by a predetermined distance (a₀, a₃, a₅).

3. Device according to Claim 1 or 2, **characterized in that** the reference line (L₂) is at least approximately a straight line.

4. Device according to Claim 1 or 2, **characterized in that** the reference line (L₁) is at least approximately the circumferential line of a rotor (3, 41).

5. Device according to one of Claims 1 to 4, **characterized in that** the sensor apparatus (21, 28, 35) comprises a plurality of sensors (22, 23; 26, 27; 36-38), which are electrically connected to one another.

6. Device according to Claim 5, **characterized in that** two sensors (21, 22) are provided whose bias parts of their layer systems have magnetization directions (M_{b1}, M_{b2}) which run at least largely at right angles to one another.

7. Device according to Claim 5, **characterized in that** three sensors (36-38) are provided whose bias parts of their layer systems have magnetization directions (M_{bi}) which between them enclose in each case at least approximately an angle (χ) of 120°.

8. Device according to one of Claims 5 to 7, **characterized in that** the sensors (22, 23; 36-38) lie in a common plane (E₁).

9. Device according to one of Claims 5 to 7, **characterized in that** the sensors (26, 27) lie in parallel planes (E₁, E₂).

10. Use of the device according to one of Claims 1 to 9 at least as part of a contactless potentiometer.

## Revendications

1. Installation (2, 20, 25, 30, 35, 40) pour détecter sans contact la position d'un objet par rapport à une position initiale prédéfinie, comportant
- un dispositif (3, 31, 41) générateur de champ magnétique qui forme un pôle magnétique (42a) sur une ligne de référence (L₁, L₂) imaginaire ou des pôles magnétiques (4ⱼ, 4ₖ) qui produisent le long de la ligne plusieurs directions de champ magnétique alternées et les uns derrière les autres,
- un dispositif de capteurs (5, 21, 28, 35) qui comporte au moins un capteur (6, 22, 23, 26, 27, 36 à 38) dans lequel passe du courant et dont l'effet magnétorésistif est augmenté et qui comporte un système de couches (8) à au moins une couche de mesure (9) magnétiquement douce dont l'aimantation (Mₘ) peut tourner dans le plan de sa couche et au moins une partie de polarisation (11) magnétiquement plus dure dont l'aimantation (M_{b}, M_{b1}, M_{b2}, M_{bi}) est au moins en grande partie inchangée et une liaison rigide de l'objet avec le dispositif de capteurs ou le dispositif générateur de champ magnétique,
dans lequel le dispositif générateur de champ magnétique peut se déplacer par rapport au dispositif de capteurs de telle manière que le champ magnétique (h, h') de l'au moins un pôle magnétique est alors détecté par la couche de mesure de l'au moins un capteur et qu'alors la ligne caractéristique des capteurs ou une partie de celle-ci est traversée un nombre de fois qui correspond au nombre (n) des pôles magnétiques détectés, sensiblement seulement une dépendance directionnelle de l'effet magnétorésistif de l'au moins un capteur étant utilisée,
**caractérisée en ce que** le dispositif générateur de champ magnétique est disposé par rapport au dispositif de capteurs de manière que l'au moins un capteur est décalé de côté par rapport à la ligne de référence imaginaire de l'au moins un pôle magnétique, une normale (Zₙ) centrale de la face polaire (Fⱼ, Fₖ, 42a) de l'au moins un pôle magnétique se trouvant au moins approximativement dans le plan (E₁) de la couche de mesure (9) de l'au moins un capteur ou dans un plan qui lui est parallèle.

2. Installation selon la revendication 1, **caractérisée en ce que** l'au moins un capteur (6, 22, 23, 26, 27, 36 à 38) est décalé de côté d'une distance (a₀, a₃, a₅) prédéfinie par rapport à la ligne de référence (L₁, L₂) imaginaire de l'au moins un pôle magnétique (4ⱼ, 4ₖ, 42a).

3. Installation selon la revendication 1 ou 2, **caractérisée en ce que** la ligne de référence (L₂) est au moins approximativement une droite.

4. Installation selon la revendication 1 ou 2, **caractérisée en ce que** la ligne de référence (L₁) est au moins approximativement la ligne périphérique d'un rotor (3, 41).

5. Installation selon l'une des revendications 1 à 4, **caractérisée en ce que** le dispositif de capteurs (21, 28, 35) comprend plusieurs capteurs (22, 23 ; 26, 27 : 36 à 38) en liaison électrique les uns avec les autres.

6. Installation selon la revendication 5, **caractérisée en ce qu'**on prévoit deux capteurs (21, 22) dont les parties de polarisation de leurs systèmes de couches ont des directions d'aimantation (M_{b1}, M_{b2}) qui font au moins approximativement un angle droit l'une par rapport à l'autre.

7. Installation selon la revendication 5, **caractérisée en ce qu'**on prévoit trois capteurs (36 à 38) dont les parties de polarisation de leurs systèmes de couches ont des directions d'aimantation (M_{bi}) qui font au moins approximativement un angle (χ) de 120° les unes par rapport aux autres.

8. Installation selon l'une des revendications 5 à 7, **caractérisée en ce que** les capteurs (22, 23 ; 36 à 38) se trouvent dans un plan (E₁) commun.

9. Installation selon l'une des revendications 5 à 7, **caractérisée en ce que** les capteurs (26, 27) se trouvent dans des plans (E₁, E₂) parallèles.

10. Utilisation de l'installation selon l'une des revendications 1 à 9 au moins comme partie d'un potentiomètre sans contact.
